# EUROPEAN PATENT APPLICATION

(11) **EP 4 600 009 A1**
(43) Date of publication of application: **13.08.2025**
(21) Application number: 25155866.4
(22) Date of filing: 04.02.2025
(51) Int. Cl.: B29C 33/30, C04B 35/80, C04B 35/83, C04B 41/45, C23C 16/04, C23C 16/458, F01D 5/28

(54) **TOOLING FOR FORCED-FLOW CHEMICAL VAPOR INFILTRATION PROCESS**

(30) Priority: 09.02.2024 US 202463551758 P
(71) Applicant: RTX Corporation, Farmington, CT 06032 (US)
(72) Inventor: SHE, Ying, East Hartford, 06118 (US); NABLE, Jun, East Hartford, 06118 (US); KOLE, Molly, East Hartford, 06118 (US)
(74) Representative: Dehns

(57) **Abstract**

A tooling assembly (10) for use in infiltrating a plurality of hollow fibrous preforms (14) includes a hollow base plate (16) disposed at a first end of the tooling assembly (10) relative to a direction of a flow of reactive gas, a solid cover plate (18) disposed at an opposing second end of the tooling assembly (10), a plurality of seal plates (20) in physical contact with disposed between adjacent ones of the plurality of fibrous preforms (14), and a plurality of support bars (22) extending between the base plate (16) and the cover plate (18) and disposed about a periphery of the tooling assembly (10).

## Description

### BACKGROUND

The present invention relates generally to chemical vapor infiltration, and more particularly to tooling for carrying out chemical vapor infiltration.

Chemical vapor infiltration (CVI) is a well-known process used in the fabrication of ceramic matrix composites (CMCs). During CVI, one or more porous ceramic preforms can be placed in a reactor and exposed to reactive precursors carried in a gaseous flow through the reactor. The gaseous flow diffuses into the porous preforms to and the reactants deposit to form a matrix of, for example, silicon carbide. One challenge of CVI is the length of time required to form a matrix via diffusion. Thus, means for accelerating CVI processing time are desirable.

### SUMMARY

A tooling assembly for use in infiltrating a plurality of hollow fibrous preforms includes a hollow base plate disposed at a first end of the tooling assembly relative to a direction of a flow of reactive gas, a solid cover plate disposed at an opposing second end of the tooling assembly, a plurality of seal plates in physical contact with disposed between adjacent ones of the plurality of fibrous preforms, and a plurality of support bars extending between the base plate and the cover plate and disposed about a periphery of the tooling assembly.

A method of infiltrating a plurality of hollow fibrous preforms includes arranging the plurality of preforms in a stack atop a hollow base plate of a tooling assembly, disposing a seal plate between adjacent ones of the plurality of preforms, positioning a solid cover plate atop the stack, aligning the hollow base plate with a source of a flow of reactive gas, and directing the flow of reactive gas into a hollow interior of the stack.

A tooling assembly for use in infiltrating a plurality of hollow fibrous preforms includes a hollow base plate disposed at a first end of the tooling assembly relative to a direction of a flow of reactive gas, a solid cover plate disposed at an opposing second end of the tooling assembly, and a plurality of seal plates in physical contact with disposed between adjacent ones of the plurality of fibrous preforms. The base plate, the cover plate, and the plurality of seal plates each have a shape complementary to a shape of each of the plurality of preforms.

Features of embodiments are set forth in the dependent claims.

### BRIEF DESCRIPTION OF THE DRAWINGS

FIG. 1 is a perspective side view of a forced-flow tooling assembly.
FIG. 2 is an exploded view showing multiple preforms and components of the forced-flow tooling assembly.
FIG. 3 is a cross-sectional illustration of a preform taken along line 3-3 of FIG. 2.

While the above-identified figures set forth one or more embodiments of the present disclosure, other embodiments are also contemplated, as noted in the discussion. In all cases, this disclosure presents the invention by way of representation and not limitation. It should be understood that numerous other modifications and embodiments can be devised by those skilled in the art, which fall within the scope and spirit of the principles of the invention. The figures may not be drawn to scale, and applications and embodiments of the present invention may include features and components not specifically shown in the drawings.

### DETAILED DESCRIPTION

This disclosure presents a tooling assembly for carrying out a forced flow CVI process in which a flow of reactive gas is introduced through the hollow interior of a stack of preforms creating a pressure gradient between the hollow interior and the external environment. The flow of reactive gas can include a reactive precursor (e.g., methyl trichlorosilane - MTS) and a process/carrier gas (e.g., H₂) which are combined to form the reactive gas.

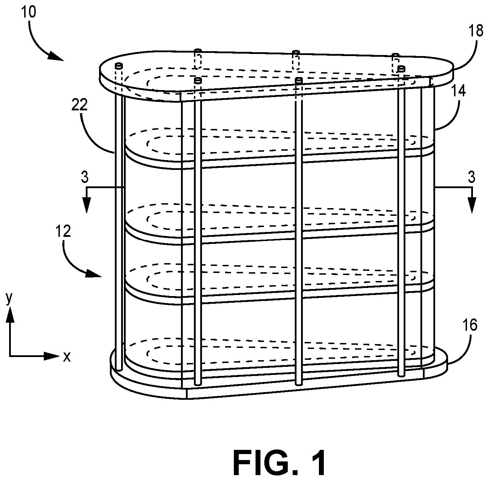

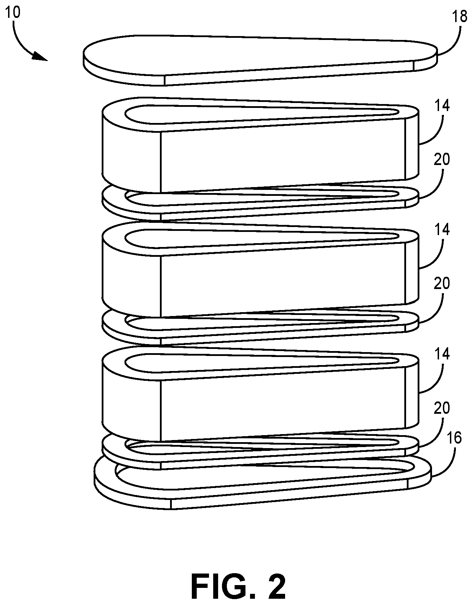

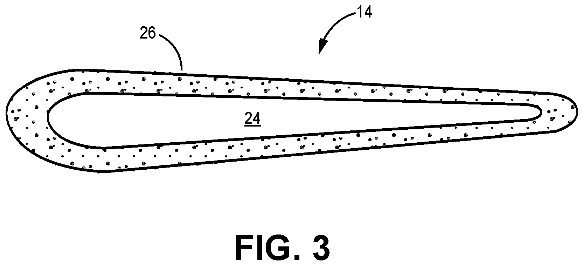

FIG. 1 is a simplified perspective side view, shown as partially transparent, of tooling assembly 10 assembled around stack 12 of preforms 14. FIG. 2 is a simplified exploded view of a portion of tooling assembly 10 and preforms 14. FIG. 3 is a cross-sectional view of a preform 14 taken along line 3-3 of FIG. 1. FIGS. 1-3 are discussed together.

Tooling assembly 10 can include base plate 16, cover plate 18, at least one seal plate 20, and support bars 22. Base plate 16 can be used to support stack 12 of preforms 14, and is hollow to allow a flow of reactant gas into an enclosed hollow interior 24 of preforms 14/stack 12 (labeled in FIG. 2). Each seal plate 20 can be similarly hollow and disposed between each preform 14 and an adjacent structure (e.g., another preform 14, base plate 16, etc.). Cover plate 18 is not hollow and can instead be solid with the exception of counterbores for receiving support bars 22. Cover plate 18 and seal plates 20 help to fluidly seal tooling assembly 10 and stack 12 to create the pressure gradient between the hollow interior 24 and the external environment, as is discussed below in greater detail. Cover plate 18 and base plate 16 can be larger (i.e., have a greater planar extent) than seal plates 20. Support bars 22 can extend between and be secured to base plate 16 and cover plate 18 about a periphery of tooling assembly 10 for supporting cover plate 18 and holding preforms 14 and seal plates 20 in place. The components of tooling assembly 10 can each be formed from a suitable high temperature material, such as graphite, or carbon-carbon composite and/or a refractory metal.

Preforms 14 can be formed from tows of a ceramic material, such as silicon carbide (SiC) arranged in one of various two or three-dimensional woven architectures such as plain, harness (e.g., 3, 5, 8, etc.), twill, braid, or non-symmetric to name a few non-limiting examples. In an alternative embodiment, preform 14 can be formed from non-woven (e.g., chopped, felted, etc.) fibers. The ceramic material can be formed into a net or near net shape structure having one or more walls 26 defining hollow interior 24. As shown in the figures, preforms 14 have an airfoil shape, but tooling assembly 10 can be used with various hollow preforms, such as an air seal assembly for a gas turbine engine. Tooling assembly 10 can be customizable based on the number and shape of preforms 14. First, base plate 16, cover plate 18, and seal plates 20 can be made to have a shape complementary to preforms 14 (e.g., airfoil shape) to facilitate sufficient sealing and flow of reactant gas into stack 12. Tooling assembly 10 can further be made to accommodate various numbers of preforms 14 by adding/removing seal plates 20 and having support bars (or rods) 22 of various lengths. One or more tooling assemblies 10 with stacks 12 of variously shaped preforms 14 can be placed in a CVI reactor to fabricate more CMCs than with unstacked configurations.

In operation, tooling assembly 10 with stack 12 of preforms 14 can be placed in a CVI reactor, with or without additional tooling assemblies 10. Base plate 16 can be positioned to overlap with an opening in a reactor support plate or other source of reactive gas flow. The flow of reactant gas can be delivered into hollow interior 24 of preforms 14/stack 12 along a flow axis (the y-axis of FIG. 1) as pressure builds within tooling assembly 10, the reactive flow is driven through walls 26 to the external environment, with deposits forming on and within walls 26 to densify preforms 14. Such forced flow infiltration can be used to densify preforms 14 in significantly less time than other methods.

The disclosed tooling assembly can be used when infiltrating preforms via CVI, to deposit interface coatings (e.g., layers of BN, SiC, Si-doped BN, etc.) and/or to form a matrix (e.g., SiC) to create a CMC component. Such CMC components can be incorporated into aerospace, maritime, or industrial equipment, to name a few, non-limiting examples.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

### Discussion of Possible Embodiments

The following are non-exclusive descriptions of possible embodiments of the present invention.

A tooling assembly for use in infiltrating a plurality of hollow fibrous preforms includes a hollow base plate disposed at a first end of the tooling assembly relative to a direction of a flow of reactive gas, a solid cover plate disposed at an opposing second end of the tooling assembly, a plurality of seal plates in physical contact with disposed between adjacent ones of the plurality of fibrous preforms, and a plurality of support bars extending between the base plate and the cover plate and disposed about a periphery of the tooling assembly.

The tooling assembly of the preceding paragraph can optionally include, additionally and/or alternatively, any one or more of the following features, configurations and/or additional components:
In the above tooling assembly, the tooling assembly can be formed from graphite.

In any of the above tooling assemblies, the tooling assembly can be formed from at least one of a carbon-carbon composite and a refractory metal.

In any of the above tooling assemblies, the base plate, the cover plate, and the plurality of seal plates can each have a shape complementary to a shape of each of the plurality of preforms.

In any of the above tooling assemblies, each of the plurality of preforms can be shaped like an airfoil.

In any of the above tooling assemblies, the base plate, the cover plate, and the plurality of seal plates can each be shaped like an airfoil.

In any of the above tooling assemblies, the cover plate and the base plate can be larger than each of the plurality of seal plates.

A method of infiltrating a plurality of hollow fibrous preforms includes arranging the plurality of preforms in a stack atop a hollow base plate of a tooling assembly, disposing a seal plate between adjacent ones of the plurality of preforms, positioning a solid cover plate atop the stack, aligning the hollow base plate with a source of a flow of reactive gas, and directing the flow of reactive gas into a hollow interior of the stack.

The method of the preceding paragraph can optionally include, additionally and/or alternatively, any one or more of the following features, configurations and/or additional steps:
The above method can further include after positioning the cover plate atop the stack, disposing a plurality of support bars between the cover plate and the base plate.

In any of the above methods, the base plate, the cover plate, and the plurality of seal plates can each have a shape complementary to a shape of each of the plurality of preforms.

In any of the above methods, each of the plurality of preforms can be shaped like an airfoil.

In any of the above methods, the base plate, the cover plate, and the plurality of seal plates can each be shaped like an airfoil.

In any of the above methods, the base plate, the cover plate, and the plurality of seal plates can be formed from graphite.

In any of the above methods, the base plate, the cover plate, and the plurality of seal plates can be formed from at least one of a carbon-carbon-composite and a refractory metal.

A tooling assembly for use in infiltrating a plurality of hollow fibrous preforms includes a hollow base plate disposed at a first end of the tooling assembly relative to a direction of a flow of reactive gas, a solid cover plate disposed at an opposing second end of the tooling assembly, and a plurality of seal plates in physical contact with disposed between adjacent ones of the plurality of fibrous preforms. The base plate, the cover plate, and the plurality of seal plates each have a shape complementary to a shape of each of the plurality of preforms.

The tooling assembly of the preceding paragraph can optionally include, additionally and/or alternatively, any one or more of the following features, configurations and/or additional components:
The above tooling assembly can further include a plurality of support bars extending between the base plate and the cover plate and disposed about a periphery of the tooling assembly.

In any of the above tooling assemblies, each of the plurality of preforms can be shaped like an airfoil.

In any of the above tooling assemblies, the base plate, the cover plate, and the plurality of seal plates can each be shaped like an airfoil.

In any of the above tooling assemblies, the tooling assembly can be formed from graphite.

In any of the above tooling assemblies, the cover plate and the base plate can be larger than each of the plurality of seal plates.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A tooling assembly (10) for use in infiltrating a plurality of hollow fibrous preforms (14), the tooling assembly (10) comprising:
a hollow base plate (16) disposed at a first end of the tooling assembly (10) relative to a direction of a flow of reactive gas;
a solid cover plate (18) disposed at an opposing second end of the tooling assembly; and
a plurality of seal plates (20) in physical contact with disposed between adjacent ones of the plurality of fibrous preforms (14),
wherein:
the tooling assembly (10) comprises a plurality of support bars (22) extending between the base plate (16) and the cover plate (18) and disposed about a periphery of the tooling assembly (10); and/or
the base plate (16), the cover plate (18), and the plurality of seal plates (20) each have a shape complementary to a shape of each of the plurality of preforms (14).

2. The tooling assembly of claim 1, wherein the tooling assembly (10) is formed from graphite.

3. The tooling assembly of claim 1, wherein the tooling assembly (10) is formed from at least one of a carbon-carbon composite and a refractory metal.

4. The tooling assembly of any preceding claim, wherein the base plate (16), the cover plate (18), and the plurality of seal plates (20) each have a shape complementary to a shape of each of the plurality of preforms (14), and each of the plurality of preforms (14) are shaped like an airfoil.

5. The tooling assembly of claim 4, wherein the base plate (16), the cover plate (18), and the plurality of seal plates (20) are each shaped like an airfoil.

6. The tooling assembly of any preceding claim, wherein the cover plate (18) and the base plate (16) are larger than each of the plurality of seal plates (20).

7. A method of infiltrating a plurality of hollow fibrous preforms (14), the method comprising:
arranging the plurality of preforms (14) in a stack (12) atop a hollow base plate (16) of a tooling assembly (10);
disposing a seal plate (20) between adjacent ones of the plurality of preforms (14);
positioning a solid cover plate (18) atop the stack (12);
aligning the hollow base plate (16) with a source of a flow of reactive gas; and
directing the flow of reactive gas into a hollow interior (24) of the stack (12).

8. The method of claim 7 and further comprising: after positioning the cover plate (18) atop the stack (12), disposing a plurality of support bars (22) between the cover plate (18) and the base plate (16).

9. The method of claim 7 or 8, wherein the base plate (16), the cover plate (18), and the plurality of seal plates (20) each have a shape complementary to a shape of each of the plurality of preforms (14).

10. The method of claim 9, wherein each of the plurality of preforms (14) are shaped like an airfoil.

11. The method of claim 10, wherein the base plate (16), the cover plate (18), and the plurality of seal plates (20) are each shaped like an airfoil.

12. The method of any of claims 7 to 11, wherein the base plate (16), the cover plate (18), and the plurality of seal plates (20) are formed from graphite.

13. The method of any of claims 7 to 11, wherein the base plate (16), the cover plate (18), and the plurality of seal plates (20) are formed from at least one of a carbon-carbon-composite and a refractory metal.
